# EUROPEAN PATENT APPLICATION

(11) **EP 4 671 870 A1**
(43) Date of publication of application: **31.12.2025**
(21) Application number: 25182909.9
(22) Date of filing: 16.06.2025
(51) Int. Cl.: G03G 15/00, H05K 1/00, H05K 7/14

(54) **IMAGE FORMING APPARATUS**

(30) Priority: 24.06.2024 JP 2024101330
(71) Applicant: KYOCERA Document Solutions Inc., Osaka-shi, Osaka 540-8585 (JP)
(72) Inventor: Sugiyama, Yuichi, Osaka-shi, 540-8585 (JP)
(74) Representative: Plougmann Vingtoft a/s

(57) **Abstract**

A board support member (8) is a metal plate member to which a printed circuit board (7) is attached. A spacer (60) is arranged between the printed circuit board (7) and the board support member (8). The board support member (8) has a clamp hole (84a) that is a through hole, and has a spacer engagement portion (84) that is an annular protrusion formed by burring. The spacer (60) has a first end formed with a clamp (61) having a flexible portion (61a) capable of being inserted through the clamp hole (84a) and engaging with the spacer engagement portion (4). The spacer (60) further has a second end (6020 opposite the first end (601) and facing the surface of the printed circuit board (7).

## Description

### INCORPORATION BY REFERENCE

This application is based upon and claims the benefit of priority from the corresponding Japanese Patent Application No. 2024-101330 filed on June 24, 2024, the entire contents of which are incorporated herein by reference.

### BACKGROUND

The present disclosure relates to an image forming apparatus including a printed circuit board fixed to a metal member.

The image forming apparatus includes a printing device that forms an image on a sheet. The image forming apparatus further includes a printed circuit board on which a power supply circuit for supplying power to the printing device or a control circuit for controlling the printing device is mounted.

The printed circuit board is fixed to a board support member, which is a metal plate member, by a plurality of screws or the like. In addition, a spacer may also be arranged between the printed circuit board and the board support member. The spacer prevents the printed circuit board from bending excessively.

For example, a spacer having a clamp formed at a first end of the spacer and an engaging groove formed at a second end of the spacer is known. In this case, the clamp is engaged with an edge portion of a hole in the printed circuit board, and the engaging groove is engaged with a notch portion in the board support member.

### SUMMARY

An image forming apparatus according to an aspect of the present disclosure includes a printing device, a printed circuit board, a board support member, and a spacer. The printing device forms an image on a sheet. The printed circuit board is a board on which a power supply circuit for supplying power to the printing device or a control circuit for controlling the printing device is mounted. The board support member is a metal plate member to which the printed circuit board is attached. The spacer is arranged between the printed circuit board and the board support member. The board support member has a clamp hole that is a through hole, and has a spacer engagement portion that is an annular protrusion formed by burring. The spacer has a first end formed with a clamp having a flexible portion capable of being inserted through the clamp hole and engaging with the spacer engagement portion. The spacer further has a second end opposite the first end and facing the surface of the printed circuit board.

This Summary is provided to introduce a selection of concepts in a simplified form that are further described below in the Detailed Description with reference where appropriate to the accompanying drawings. This Summary is not intended to identify key features or essential features of the claimed subject matter, nor is it intended to be used to limit the scope of the claimed subject matter. Furthermore, the claimed subject matter is not limited to implementations that solve any or all disadvantages noted in any part of this disclosure.

### BRIEF DESCRIPTION OF THE DRAWINGS

FIG. 1 is a diagram showing a configuration of an image forming apparatus according to an embodiment.
FIG. 2 is a plan view of a board support structure in an image forming apparatus according to an embodiment.
FIG. 3 is a plan view of a portion of a board support member in a board support structure in an image forming apparatus according to an embodiment.
FIG. 4 is a cross-sectional view of a peripheral portion of one of a plurality of board fixing portions in a board support structure in an image forming apparatus according to an embodiment.
FIG. 5 is an exploded cross-sectional view of a peripheral portion of one of a plurality of board fixing portions in a board support structure in an image forming apparatus according to an embodiment.
FIG. 6 is a cross-sectional view of a peripheral portion of a spacer in a board support structure in an image forming apparatus according to an embodiment.
FIG. 7 is an exploded cross-sectional view of a peripheral portion of a spacer in a board support structure in an image forming apparatus according to an embodiment.

### DETAILED DESCRIPTION

Hereinafter, embodiments according to the present disclosure will be described with reference to the drawings. Note that the following embodiments are examples of a technique according to the present disclosure and do not limit the technical scope of the present disclosure.

An image forming apparatus 10 according to an embodiment is capable of executing a printing process for forming an image on a sheet 9.

### [Configuration of Image Forming Apparatus 10]

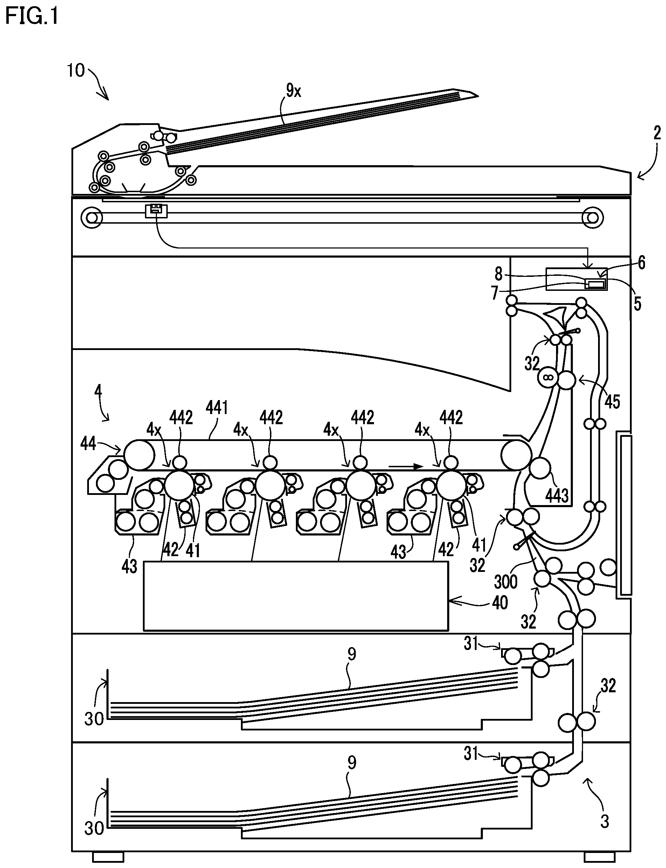

As shown in FIG. 1, the image forming apparatus 10 includes a sheet conveying mechanism 3 and a printing device 4. In the present embodiment, the image forming apparatus 10 also includes an image reading device 2 that reads an image from an original document 9x.

The sheet conveying mechanism 3 conveys the sheet 9 stored in the sheet storing portion 30 along a conveying path 300. The sheet conveying mechanism 3 includes a sheet feeding mechanism 31 and a plurality of sets of conveying roller pairs 32.

The sheet feeding mechanism 31 feeds the sheet 9 from the sheet storing portion 30 to the conveying path 300. The plurality of sets of conveying roller pairs 32 convey the sheet 9 along the conveying path 300.

The printing device 4 forms an image on the sheet 9 conveyed along the conveying path 300. One set of the plurality of sets of conveying roller pairs 32 discharges the sheet 9 on which an image has been formed from the conveying path 300.

In the example shown in FIG. 1, the printing device 4 executes a printing process by an electrophotographic method. In this case, the printing device 4 includes a laser scanning unit 40, one or more image forming portions 4x, a transfer device 44, and a fixing device 45.

Each image forming portion 4x includes a photoconductor 41, a charging device 42, and a developing device 43. The charging device 42 charges a surface of the photoconductor 41. The laser scanning unit 40, by scanning a laser beam over the charged surface of the photoconductor 41, forms an electrostatic latent image on the surface of the photoconductor 41.

The developing device 43, by supplying toner to the surface of the photoconductor 41, develops the electrostatic latent image into a toner image. The photoconductor 41 is an image carrier that carries the toner image.

The transfer device 44 transfers the toner image on the surface of the photoconductor 41 onto the sheet 9. The fixing device 45 applies heat and pressure to the toner image transferred onto the sheet 9 to fix the toner image onto the sheet 9.

In the example shown in FIG. 1, the printing device 4 is a tandem-type color printing device. Therefore, the printing device 4 is provided with a plurality of image forming portions 4x corresponding to a plurality of developing colors.

In addition, the transfer device 44 includes an intermediate transfer belt 441, and a plurality of primary transfer devices 442 and secondary transfer devices 443 corresponding to the plurality of image forming portions 4x.

Each primary transfer device 442 transfers the toner image on the photoconductor 41 of each image forming portion 4x onto the surface of the intermediate transfer belt 441. The secondary transfer device 443 transfers the toner image on the surface of the intermediate transfer belt 441 onto the sheet 9.

Note that the printing device 4 may be a device that forms an image on the sheet 9 by a method other than the electrophotographic method. For example, the printing device 4 may be a device that forms an image on the sheet 9 by an inkjet method.

The image forming apparatus 10 further includes a control device 5 that controls the image reading device 2, the sheet conveying mechanism 3 and the printing device 4. The control device 5 executes various types of data processing operations and controls various types of devices in the image forming apparatus 10.

### [Board Support Structure 6]

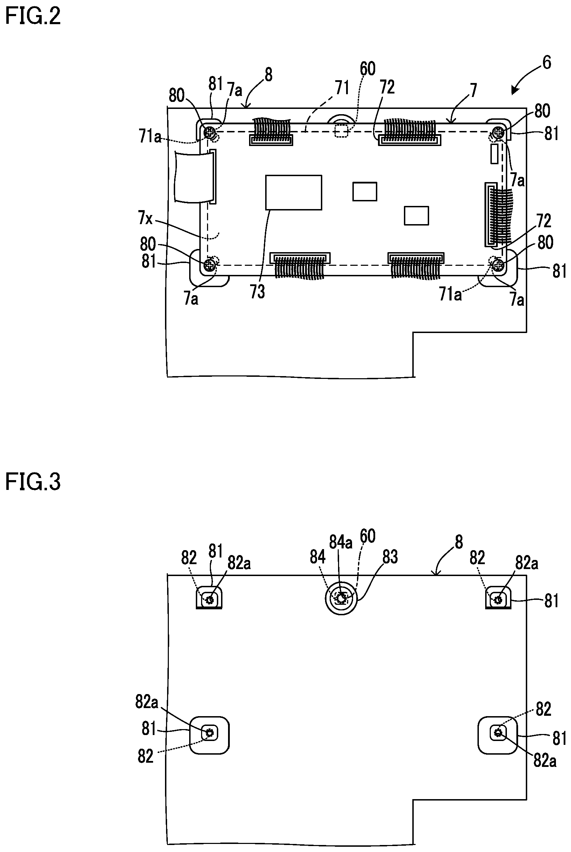

The control device 5 includes a board support structure 6 including a printed circuit board 7 and a board support member 8 on which the printed circuit board 7 is mounted (see FIGS. 1 and 2).

The printed circuit board 7 is a board on which a circuit 71 including a power supply circuit and/or a control circuit is mounted. The circuit 71, in addition to pattern wiring, includes mounting components such as a connector 72 and an IC 73. The power supply circuit supplies power to the printing device 4. The control circuit controls the printing device 4.

The board support member 8 is a metal plate member. The board support structure 6 includes a plurality of screws 80 that secure the printed circuit board 7 to the board support member 8. In the present embodiment, four screws 80 secure four corners of a generally rectangular printed circuit board 7 to the board support member 8 (see FIG. 2).

The board support structure 6 further includes a spacer 60 arranged between the printed circuit board 7 and the board support member 8 (see FIGS. 2, 3, 6 and 7).

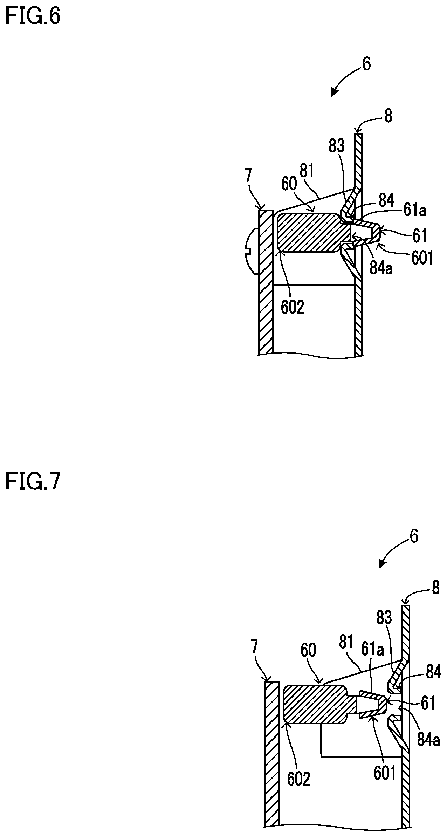

The spacer 60 prevents the printed circuit board 7 from bending excessively. In the present embodiment, the spacer 60 has a clamp 61 (FIGS. 6 and 7).

In a case in which the spacer 60 is attached to the printed circuit board 7, a mounting hole for the spacer 60 is formed in the printed circuit board 7. The wiring pattern and the mounted components are arranged in an area of the printed circuit board 7 other than areas of the mounting holes.

Therefore, in a case in which the spacer 60 is attached to the printed circuit board 7, the size of the printed circuit board 7 may become large.

Alternatively, it is conceivable that the clamp 61 of the spacer 60 is fastened to the board support member 8. However, there are cases in which the metal plate of the board support member 8 does not have a sufficient thickness for stable attachment of the clamp 61.

In addition, when the spacer 60 is attached to the board support member 8 by screws, the number of attachment steps increases.

The board support structure 6 has a configuration that enables the spacer 60, which is arranged between the printed circuit board 7 and the board support member 8, to be easily and stably attached to the board support member 8. The configuration will be described below.

The board support member 8 has a plurality of board fixing portions 81 and a plurality of screw fitting portions 82 formed on the board fixing portions 81 (see FIG. 3).

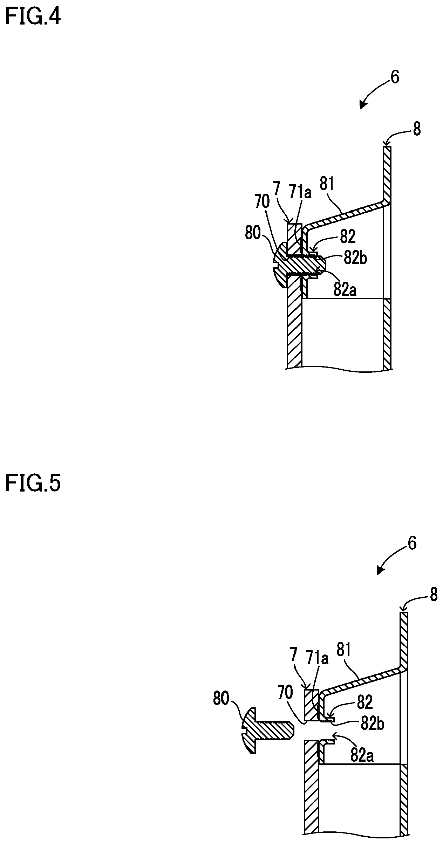

Each of the board fixing portions 81 is a raised portion formed by drawing so as to face a specific surface 7x of the printed circuit board 7 (see FIGS. 4 and 5). Each screw fitting portion 82 is formed on a top portion of each board fixing portion 81.

The plurality of screw fitting portions 82 are a plurality of annular protrusions formed by burring (see FIGS. 3 to 5). In the present embodiment, each of the screw fitting portions 82 protrudes toward an opposite side to the printed circuit board 7 side.

The plurality of screw fitting portions 82 form a plurality of screw holes 82a that are holes that penetrate through the plurality of board fixing portions 81. A screw thread 82b is formed on an inner surface of each of the screw fitting portions 82 (see FIGS. 4 and 5).

In the present embodiment, the board support member 8 has four board fixing portions 81 and four screw fitting portions 82 corresponding to four screws 80.

The four screws 80 are inserted through four through holes 70 formed in four corners of the printed circuit board 7 and screwed into the four screw fitting portions 82. Thus, the four screws 80 fix the printed circuit board 7 to the four board fixing portions 81.

The circuit 71 of the printed circuit board 7 has a ground pattern 71a formed on at least a part of four contact portions 7a that come into contact with the four board fixing portions 81 of the printed circuit board 7 (see FIG. 2).

In the present embodiment, the four contact portions 7a are four corner portions on a specific surface 7x of the printed circuit board 7. In the example shown in FIG. 2, the ground pattern 71a is formed on the four contact portions 7a.

By fixing the printed circuit board 7 to the four board fixing portions 81 by four screws 80, the board support member 8 functions as a ground conductor. Therefore, no ground wire is required.

The board support member 8 has a spacer engagement portion 84 that is an annular protrusion formed by burring (see FIGS. 3, 6 and 7). The spacer engagement portion 84 has a clamp hole 84a formed on an inner side thereof as a through hole. In the present embodiment, the spacer engagement portion 84 protrudes toward the opposite side to the printed circuit board 7 side. Note that the spacer engagement portion 84 may protrude toward the printed circuit board 7 side.

The spacer 60 has a first end 601 where the clamp 61 is formed, and a second end 602 opposite the first end 601 (see FIGS. 6 and 7). The clamp 61 has a flexible portion 61a that is inserted into the clamp hole 84a and engages with the spacer engagement portion 84.

By inserting the clamp 61 into the clamp hole 84a, the flexible portion 61a deforms so that the width narrows while the flexible portion 61a is passing through the clamp hole 84a, and then returns to its original shape after passing through the clamp hole 84a, thereby engaging with the spacer engagement portion 84.

The spacer engagement portion 84 is formed with a necessary and sufficient height for stable attachment of the clamp 61. Therefore, regardless of the thickness of the metal plate of the board support member 8, the clamp 61 can be stably fastened to the spacer engagement portion 84.

The second end 602 of the spacer 60 faces the specific surface 7x of the printed circuit board 7. The specific surface 7x is one of two surfaces of the printed circuit board 7. A distance between the second end 602 of the spacer 60 and the specific surface 7x of the printed circuit board 7 is designed according to the allowable amount of bending of the printed circuit board 7.

When necessary, a configuration in which the second end 602 of the spacer 60 contacts the specific surface 7x of the printed circuit board 7 may be adopted.

In the present embodiment, the board support member 8 has a spacer mounting portion 83 that is a raised portion formed by drawing so as to face the specific surface 7x of the printed circuit board 7 (see FIGS. 3, 6 and 7). The spacer engagement portion 84 is formed on the top portion of the spacer mounting portion 83.

As shown in FIGS. 6 and 7, the spacer mounting portions 83 are raised portions that are shorter than each of the board fixing portions 81. In other words, each of the board fixing portions 81 is a raised portion that is taller than the spacer mounting portion 83.

By employing the board support structure 6, the spacer 60 can be attached to the board support member 8 easily and stably.

In addition, by forming the spacer engagement portion 84 on the spacer mounting portion 83 that is formed by drawing, at least a portion of the clamp 61 fits inside the spacer mounting portion 83. Therefore, the height that the clamp 61 protrudes from the board support member 8 is reduced, and the degree of freedom in arranging the board support member 8 is increased.

Moreover, the spacer mounting portion 83 formed by drawing has higher dimensional accuracy and strength than a portion formed by cutting and bending a part of the metal plate. Therefore, the spacer 60 is stably held with high positional accuracy.

Furthermore, it is possible to form a plurality of board fixing portions 81 and one or more spacer mounting portions 83 in a single drawing process. Therefore, the board support member 8 can be easily processed.

### [Supplementary Notes]

An outline of the invention extracted from the above-described embodiments will be added below. Note that the configurations and processing functions described in the following supplementary notes can be selected and combined as desired.

### <Supplementary Note 1>

An image forming apparatus, including:
a printing device configured to form an image on a sheet;
a printed circuit board on which a power supply circuit for supplying power to the printing device or a control circuit for controlling the printing device is mounted;
a board support member that is a metal plate member to which the printed circuit board is attached; and
a spacer arranged between the printed circuit board and the board support member; wherein
the board support member has a clamp hole formed as a through hole, and has a spacer engagement portion that is an annular protrusion formed by burring;
the spacer has
a first end having a clamp formed thereon, the clamp portion having a flexible portion that is inserted into the clamp hole and engages with the spacer engagement portion; and
a second end on an opposite side of the first end and facing a surface of the printed circuit board.

### <Supplementary Note 2>

The image forming apparatus according to Supplementary Note 1, wherein
the board support member has a spacer mounting portion that is a raised portion formed by drawing so as to face the printed circuit board; and
the spacer engagement portion is formed on the spacer mounting portion.

### <Supplementary Note 3>

The image forming apparatus according to Supplementary Note 2, including
a plurality of screws for fixing the printed circuit board to the board support member; wherein
the board support member has:
a plurality of board fixing portions that are raised portions formed by drawing to face the printed circuit board; and
a plurality of screw fitting portions that are a plurality of annular protrusions formed by burring in which a plurality of screw holes are formed as through holes penetrating the plurality of board fixing portions, with screw threads formed on an inner surface of the screw holes; wherein
the plurality of screws are inserted through a plurality of through holes formed in the printed circuit board and screwed into the plurality of screw fitting portions, thereby fixing the printed circuit board to the plurality of board fixing portions.

### <Supplementary Note 4>

The image forming apparatus according to Supplementary Note 3, wherein
the printed circuit board has a ground pattern formed on at least a portion of a plurality of contact portions that come into contact with the plurality of board fixing portions of the printed circuit board.

It is to be understood that the embodiments herein are illustrative and not restrictive, since the scope of the disclosure is defined by the appended claims rather than by the description preceding them, and all changes that fall within metes and bounds of the claims, or equivalence of such metes and bounds thereof are therefore intended to be embraced by the claims.

## Claims

1. An image forming apparatus (10), comprising:
a printing device (4) configured to form an image on a sheet;
a printed circuit board (7) on which a power supply circuit for supplying power to the printing device (4) or a control circuit for controlling the printing device (4) is mounted;
a board support member (8) that is a metal plate member to which the printed circuit board (7) is attached; and
a spacer (60) arranged between the printed circuit board (7) and the board support member (8); wherein
the board support member (8) has a clamp hole (84a) formed as a through hole, and has a spacer engagement portion (84) that is an annular protrusion formed by burring;
the spacer (6) has
a first end (601) having a clamp (61) formed thereon, the clamp (61) having a flexible portion (61a) that is inserted into the clamp hole (84a) and engages with the spacer engagement portion (84); and
a second end (602) on an opposite side of the first end (601) and facing a surface of the printed circuit board (7).

2. The image forming apparatus (10) according to claim 1, wherein
the board support member (8) has a spacer mounting portion (83) that is a raised portion formed by drawing so as to face the printed circuit board (7); and
the spacer engagement portion (84) is formed on the spacer mounting portion (83).

3. The image forming apparatus (10) according to claim 2, comprising
a plurality of screws (80) for fixing the printed circuit board (7) to the board support member (8); wherein
the board support member (8) has:
a plurality of board fixing portions (81) that are raised portions formed by drawing to face the printed circuit board (7); and
a plurality of screw fitting portions (82) that are a plurality of annular protrusions formed by burring in which a plurality of screw holes are formed as through holes penetrating the plurality of board fixing portions (81), with screw threads formed on an inner surface of the screw holes; wherein
the plurality of screws (80) are inserted through a plurality of through holes formed in the printed circuit board (7) and screwed into the plurality of screw fitting portions (82), thereby fixing the printed circuit board (7) to the plurality of board fixing portions (81).

4. The image forming apparatus (10) according to claim 3, wherein
the printed circuit board (7) has a ground pattern (71a) formed on at least a portion of a plurality of contact portions (7a) that come into contact with the plurality of board fixing portions (81) of the printed circuit board (7).
